# EUROPÄISCHE PATENTANMELDUNG

(11) **EP 4 325 366 A1**
(43) Veröffentlichungstag der Anmeldung: **21.02.2024**
(21) Anmeldenummer: 22193650.3
(22) Anmeldetag: 02.09.2022
(51) Int. Cl.: G06F 11/36

(54) **VERFAHREN UND SYSTEM ZUM AUSFÜHREN EINES VIRTUELLEN TESTS**

(30) Priorität: 17.08.2022 DE 102022127054
(71) Anmelder: dSPACE GmbH, 33102 Paderborn (DE)
(72) Erfinder: Werth, Matthias, 33100 Paderborn (DE); Misch, Thomas, 33102 Paderborn (DE)

(57) **Zusammenfassung**

Die Erfindung betrifft ein Verfahren und System (1)zum Ausführen eines virtuellen Tests einer Vorrichtung (10) zur zumindest teilweisen autonomen Führung eines Kraftfahrzeugs, umfassend ein Ausführen (S2) des virtuellen Tests durch einen Algorithmus (A) unter Verwendung des zumindest eines Parametersatzes (P) von Fahrsituationsparametern, wobei der durch den Algorithmus (A) ausgeführte virtuelle Test den zumindest einen Parametersatz (P) von Fahrsituationsparametern simuliert; und bei Erfüllen einer vorgegebenen und/oder durch den Algorithmus (A) bestimmten Bedingung (B), Verändern (S4) des zumindest einen, durch den zumindest einen Fahrzeugsensor (12a) erfassten ersten Parameters (P1) und/oder eines, einen Fahrzeugaktor (12b) betreffenden dritten Parameters (P3) zu einer Laufzeit des virtuellen Tests.

## Beschreibung

Die vorliegende Erfindung betrifft ein computerimplementiertes Verfahren zum Ausführen eines virtuellen Tests einer Vorrichtung zur zumindest teilweisen autonomen Führung eines Kraftfahrzeugs.

Die vorliegende Erfindung betrifft des Weiteren ein System zum Ausführen eines virtuellen Tests einer Vorrichtung zur zumindest teilweisen autonomen Führung eines Kraftfahrzeugs.

Darüber hinaus betrifft die Erfindung ein Computerprogramm mit Programmcode, um das erfindungsgemäße Verfahren durchzuführen.

### Stand der Technik

Fahrassistenzsysteme, d.h. Vorrichtungen zur zumindest teilweisen autonomen Führung eines Kraftfahrzeugs, wie z.B. ein adaptiver Geschwindigkeitsregler und/oder Funktionen für das hochautomatisierte Fahren können mithilfe diverser Überprüfungsmethoden verifiziert bzw. validiert werden. Dabei können insbesondere Simulationen verwendet werden.

Herkömmlicherweise ist ein den virtuellen Test ausführender Algorithmus, insbesondere ein ITC Algorithmus dabei in der Lage, bestimmte Testfälle von Interesse innerhalb eines vorgegebenen Parameterraums zu identifizieren.

Die Testausführung erfolgt dabei unter der Annahme, das sämtliche Umfeld- sowie Fahrzeugdaten des Kraftfahrzeugs unter Verwendung einwandfrei funktionierender Sensoren bzw. Erfassungskomponenten bereitgestellt werden, so dass die erzeugten Daten eine Fahrsituation des Kraftfahrzeugs exakt abbilden.

Sollte jedoch im realen Fahrbetrieb beispielsweise ein Sensor bzw. eine Erfassungskomponente und/oder ein Aktor eine Fehlfunktion bzw. eine eingeschränkte Leistungsfähigkeit aufweisen, so liefert ein die Sensordaten verarbeitender Algorithmus fehlerhafte Ausgabedaten, was wiederum zu einer fehlerhaften Ansteuerung entsprechender Aktorik führen kann.

Demzufolge besteht ein Bedarf, bestehende Testverfahren für Fahrassistenzsysteme dahingehend zu verbessern, dass der die Sensordaten verarbeitende Algorithmus selbst bei durch eine Fehlfunktion bzw. eingeschränkte Leistungsfähigkeit aufweisenden Sensoren erzeugten, fehlerhaften Eingabedaten das Ausgeben fehlerhafter Ausgabedaten zum Ansteuern entsprechender Aktorik vermeidet.

Es ist daher Aufgabe der Erfindung, ein Verfahren zum Ausführen eines virtuellen Tests einer Vorrichtung zur zumindest teilweisen autonomen Führung eines Kraftfahrzeugs bereitzustellen, welches selbst bei durch eine Fehlfunktion bzw. eingeschränkte Leistungsfähigkeit aufweisenden Sensoren erzeugten, fehlerhaften Eingabedaten das Ausgeben fehlerhafter Ausgabedaten zum Ansteuern entsprechender Aktorik vermeidet.

### Offenbarung der Erfindung

Die Aufgabe wird erfindungsgemäß durch ein computerimplementiertes Verfahren zum Ausführen eines virtuellen Tests einer Vorrichtung zur zumindest teilweisen autonomen Führung eines Kraftfahrzeugs mit den Merkmalen des Patentanspruchs 1 gelöst.

Die Aufgabe wird erfindungsgemäß des Weiteren durch ein System zum Ausführen eines virtuellen Tests einer Vorrichtung zur zumindest teilweisen autonomen Führung eines Kraftfahrzeugs mit den Merkmalen des Patentanspruchs 14 gelöst.

Die Aufgabe wird erfindungsgemäß ferner durch ein Computerprogramm mit Programmcode, um das erfindungsgemäße Verfahren durchzuführen, mit den Merkmalen des Patentanspruchs 15 gelöst.

Die Erfindung betrifft ein computerimplementiertes Verfahren zum Ausführen eines virtuellen Tests einer Vorrichtung zur zumindest teilweisen autonomen Führung eines Kraftfahrzeugs.

Das Verfahren umfasst ein Bereitstellen zumindest eines Parametersatzes von Fahrsituationsparametern, wobei die Fahrsituationsparameter zumindest einen, durch zumindest einen Fahrzeugsensor erfassten ersten Parameter und zumindest einen, zumindest ein weiteres Szenarienobjekt repräsentierenden zweiten Parameter umfassen.

Des Weiteren umfasst das Verfahren ein Ausführen des virtuellen Tests durch einen Algorithmus unter Verwendung des zumindest eines Parametersatzes von Fahrsituationsparametern, wobei der durch den Algorithmus ausgeführte virtuelle Test den zumindest einen Parametersatz von Fahrsituationsparametern simuliert.

Die Erfindung umfasst überdies ein Überwachen zumindest eines Fahrsituationsparameters des Parametersatzes von Fahrsituationsparametern, und bei Erfüllen einer vorgegebenen und/oder durch den Algorithmus bestimmten Bedingung, Verändern des zumindest einen, durch den zumindest einen Fahrzeugsensor erfassten ersten Parameters und/oder eines, einen Fahrzeugaktor betreffenden dritten Parameters zu einer Laufzeit des virtuellen Tests.

Die Erfindung betrifft ferner ein System zum Ausführen eines virtuellen Tests einer Vorrichtung zur zumindest teilweisen autonomen Führung eines Kraftfahrzeugs.

Das System umfasst einen Datenspeicher, welcher dazu eingerichtet ist, zumindest einen Parametersatz von Fahrsituationsparametern bereitzustellen, wobei die Fahrsituationsparameter zumindest einen, durch zumindest einen Fahrzeugsensor erfassten ersten Parameter und zumindest einen, zumindest ein weiteres Szenarienobjekt repräsentierenden zweiten Parameter umfassen.

Darüber hinaus umfasst das System eine Rechenvorrichtung, welche dazu eingerichtet ist, den virtuellen Test durch einen Algorithmus unter Verwendung des zumindest eines Parametersatzes von Fahrsituationsparametern auszuführen, wobei der durch den Algorithmus ausgeführte virtuelle Test den zumindest einen Parametersatz von Fahrsituationsparametern simuliert, wobei die Rechenvorrichtung dazu eingerichtet ist, zumindest einen Fahrsituationsparameter des Parametersatzes von Fahrsituationsparametern zu überwachen, und wobei die Rechenvorrichtung ferner dazu eingerichtet ist, bei Erfüllen einer vorgegebenen und/oder durch den Algorithmus bestimmten Bedingung, den zumindest einen, durch den zumindest einen Fahrzeugsensor erfassten ersten Parameter und/oder einen, einen Fahrzeugaktor betreffenden dritten Parameter zu einer Laufzeit des virtuellen Tests zu verändern.

Die Erfindung betrifft des Weiteren ein Computerprogramm mit Programmcode, um das erfindungsgemäße Verfahren durchzuführen, wenn das Computerprogramm auf einem Computer ausgeführt wird.

Das weitere Szenarienobjekt bezieht sich dabei beispielsweise auf ein, abgesehen von einem den zumindest einen Fahrzeugsensor umfassenden Ego- bzw. Testfahrzeug, weiteres Objekt wie ein Fahrzeug, ein Fußgänger oder ein stationäres Objekt.

Der Parametersatzes von Fahrsituationsparametern umfasst hierbei Sensordaten bzw. Sensorsignale von Fahrzeugsensoren.

Der virtuelle Test des zumindest einen Parametersatzes von Fahrsituationsparametern umfasst ein, eine Mehrzahl von Szenarienobjekten aufweisendes Szenario bzw. Testszenario.

Das dem virtuellen Test zugrunde liegende Szenario kann dabei zum einen durch Fahrsituationsparameter bzw. Umgebungsparameter bestimmt oder zum anderen ein logisches Szenario sein, welches selbst eine Mehrzahl von Szenarien umfasst bzw. repräsentiert.

Ferner kann das Szenario beispielsweise durch ein Data Replay Szenario gebildet sein, in dem lediglich zuvor aufgenommene Fahrsituationen zum Test wieder abgespielt werden.

Eine Idee der vorliegenden Erfindung ist es, durch Verändern des zumindest einen, durch den zumindest einen Fahrzeugsensor erfassten ersten Parameter und/oder den, den Fahrzeugaktor betreffenden dritten Parameter zu einer Laufzeit des virtuellen Tests eine Fehlfunktion des Sensors und/oder des Aktors sowie ein Verhalten eines zu testenden Steuergeräts und/oder einer Fahrerassistenzfunktion auf die Fehlfunktion des Sensors und/oder des Aktors testen zu können.

Somit kann eine Konzentration der virtuellen Tests auf notwendige bzw. sinnvolle Fehlersimulationen erhöht sowie eine Anzahl unnötiger, repetitiver bzw. nicht aussagekräftiger Tests deutlich reduziert werden, was in einem Effizienzgewinn resultiert. Ferner können dadurch auch Tests bzw. Testsituationen durchgeführt werden, die ein Tester manuell ggf. übersehen hätte.

Durch das Verändern bzw. Schreiben der Variable können daher neue Testverläufe gestartet werden. Das erfindungsgemäße Verfahren testet somit eine Reaktion des Systems bzw. der zugrundeliegenden Fahrerassistenzfunktion in dem Szenario auf den eingeführten Fehlerzustand. Somit kann auf Basis der virtuellen Tests eine die betreffende Fahrerassistenzfunktion durchführende Steuergeräte-Software kontinuierlich verbessert werden.

Weitere Ausführungsformen der vorliegenden Erfindung sind Gegenstand der weiteren Unteransprüche und der nachfolgenden Beschreibung unter Bezugnahme auf die Figuren.

Gemäß einer bevorzugten Weiterbildung der Erfindung ist vorgesehen, dass die vorgegebene und/oder durch den Algorithmus bestimmte Bedingung erfüllt ist, wenn zumindest einer der bereitgestellten Fahrsituationsparameter und/oder ein eine Mehrzahl von Fahrsituationsparametern repräsentierender Indikator außerhalb eines vorgegebenen und/oder durch den Algorithmus bestimmten Wertebereichs liegt.

Somit liegt ein vorgegebenes Kriterium vor, anhand welchem das Starten eines neuen Testverlaufs durchgeführt werden kann, in welchem ein definierter Fehlerzustand eines Sensors und/oder Aktors in dem gegebenen Szenario getestet wird.

Gemäß einer weiteren bevorzugten Weiterbildung der Erfindung ist vorgesehen, dass außerhalb des vorgegebenen und/oder durch den Algorithmus bestimmten Wertebereichs liegende Werte eine sicherheitskritische Fahrsituation repräsentieren, insbesondere dass ein longitudinaler und/oder seitlicher Abstand eines Ego-Fahrzeugs zu einem Fellow-Fahrzeug kleiner oder gleich einem vorgegebenen Schwellwert ist.

Somit kann speziell in sicherheitskritischen Fahrsituation zusätzlich eine Fehlfunktion und/oder ein Ausfall zumindest einen Fahrzeugsensors und/oder Fahrzeugaktors getestet werden.

Gemäß einer weiteren bevorzugten Weiterbildung der Erfindung ist vorgesehen, dass die außerhalb des vorgegebenen und/oder durch den Algorithmus bestimmten Wertebereichs liegenden Werte der Fahrsituationsparameter, welche die sicherheitskritische Fahrsituation repräsentieren, innerhalb eines Parameterraums liegen. Der Parameterraum bildet somit Fahrsituationsparameter von Interesse ab, welche insbesondere sicherheitskritische Fahrsituation betreffen.

Gemäß einer weiteren bevorzugten Weiterbildung der Erfindung ist vorgesehen, dass der Algorithmus innerhalb des Parameterraums die sicherheitskritische Fahrsituation repräsentierenden Testfälle bestimmt. Der Algorithmus ist somit in der Lage, automatisiert sicherheitskritische Fahrsituationen von Interesse in dem vorgegebenen Parameterraum zu identifizieren, basierend auf welchen sodann fehlerhafte Sensoren und/oder Aktoren getestet werden können.

Gemäß einer weiteren bevorzugten Weiterbildung der Erfindung ist vorgesehen, dass das Verändern des zumindest einen, durch den zumindest einen Fahrzeugsensor erfassten ersten Parameters und/oder des, den Fahrzeugaktor betreffenden dritten Parameters zur Laufzeit des virtuellen Tests ein Erzeugen eines Ausfalls und/oder einer Fehlfunktion des zumindest einen Fahrzeugsensors und/oder des zumindest einen Fahrzeugaktors repräsentiert.

Das Verändern des Parameters weist daher denselben Effekt auf, als wenn ein Fahrzeugsensor beispielweise fehlerhafte Daten erzeugt.

Gemäß einer weiteren bevorzugten Weiterbildung der Erfindung ist vorgesehen, dass das Erzeugen des Ausfalls und/oder der Fehlfunktion des zumindest einen Fahrzeugsensors und/oder des zumindest einen Fahrzeugaktors eine Unterbrechung einer Kommunikationsverbindung zwischen einem Steuergerät und dem Fahrzeugsensor und/oder Fahrzeugaktor, eine Unterbrechung einer Stromversorgung des Fahrzeugsensors und/oder Fahrzeugaktors und eine Einschränkung einer Leistungsfähigkeit des Fahrzeugsensors, insbesondere aufgrund einer Verschmutzung des Fahrzeugsensors, umfasst.

Somit können in vorteilhafter Weise Vielzahl unterschiedlicher Fehlerzustände bzw. Fehlfunktionen von Fahrzeugsensoren und/oder Fahrzeugaktoren getestet werden.

Gemäß einer weiteren bevorzugten Weiterbildung der Erfindung ist vorgesehen, dass der Algorithmus Variablenwerte für das Erzeugen des Ausfalls und/oder einer Fehlfunktion des zumindest einen Fahrzeugsensors und/oder des zumindest einen Fahrzeugaktors bestimmt.

Der Algorithmus ist somit in vorteilhafter Weise in der Lage, eine Art sowie einen Grad der getesteten Sensor- bzw. Aktorfehlfunktion zu bestimmen.

Gemäß einer weiteren bevorzugten Weiterbildung der Erfindung ist vorgesehen, dass der Algorithmus für redundante und/oder unterschiedliche Fahrzeugsensoren widersprüchliche, insbesondere zueinander inkonsistente Daten erzeugt. Das System bzw. die zugrunde liegende Fahrerassistenzfunktion kann somit in einem Szenario getestet werden, in welchem beispielsweise identische Sensoren unterschiedliche Daten bezüglich derselben Szene erzeugen.

Gemäß einer weiteren bevorzugten Weiterbildung der Erfindung ist vorgesehen, dass das Verändern des zumindest einen, durch den zumindest einen Fahrzeugsensor erfassten ersten Parameters und/oder des, den Fahrzeugaktor betreffenden dritten Parameters zur Laufzeit des virtuellen Tests ein Schreiben einer den zumindest einen Fahrsituationsparameter repräsentierenden Variable umfasst. Das Schreiben der Variable ermöglicht somit das Einführen eines Fehlerzustands eines Fahrzeugsensors und/oder Fahrzeugaktors in das zu testende Szenario.

Gemäß einer weiteren bevorzugten Weiterbildung der Erfindung ist vorgesehen, dass der Fahrzeugsensor ein Kamerasensor, ein Radarsensor, ein LiDAR-Sensor, ein Ultraschallsensor, ein Infrarotsensor, ein Reifendrucksensor, ein Raddrehzahlsensor und/oder ein GNSS-Sensor, insbesondere ein GPS-Sensor ist, und wobei der Fahrzeugaktor ein adaptiver Tempomat, ein Spurhalteassistent, ein aktiver Bremsassistent und/oder ein Parkassistent ist. Somit können Fehlfunktionen und/oder ein Ausfall einer Vielzahl verschiedener Sensorarten sowie Aktorarten getestet werden.

Gemäß einer weiteren bevorzugten Weiterbildung der Erfindung ist vorgesehen, dass der durch den Fahrzeugsensor erfasste erste Parameter eine Fahrzeuggeschwindigkeit eines Ego-Fahrzeugs, ein Abstand des Ego-Fahrzeugs zu einem vorausfahrenden oder hinterherfahrenden Fellow-Fahrzeug und/oder eine Beschleunigung oder Verzögerung des Ego-Fahrzeugs und/oder eines Fellow-Fahrzeugs ist.

Auf Grundlage des ersten Parameters kann somit unter Verwendung eines entsprechenden Wertebereiches eine kritische Fahrsituationen definiert werden.

Gemäß einer weiteren bevorzugten Weiterbildung der Erfindung ist vorgesehen, dass der zumindest eine, zumindest ein weiteres Szenarienobjekt repräsentierende zweite Parameter eine Fahrbahnbreite, ein Straßenverlauf, Verkehrszeichen, Verkehrsteilnehmer, Gebäude und/oder eine Vegetation ist.

Der zweite Parameter trägt somit in Kombination mit dem ersten Parameter zur Bestimmung kritischer Fahrsituationen bei, auf Grundlage welcher die Fehlfunktion bzw. der Ausfall von Sensoren und/oder Aktoren getestet werden kann.

Die hierin beschriebenen Merkmale des Verfahrens zum Ausführen eines virtuellen Tests einer Vorrichtung zur zumindest teilweisen autonomen Führung eines Kraftfahrzeugs sind ebenso auf das erfindungsgemäße System zum Ausführen eines virtuellen Tests einer Vorrichtung zur zumindest teilweisen autonomen Führung eines Kraftfahrzeugs und umgekehrt anwendbar.

### Kurze Beschreibung der Zeichnungen

Zum besseren Verständnis der vorliegenden Erfindung und ihrer Vorteile wird nun auf die nachfolgende Beschreibung in Verbindung mit den zugehörigen Zeichnungen verwiesen.

Nachfolgend wird die Erfindung anhand exemplarischer Ausführungsformen näher erläutert, die in den schematischen Abbildungen der Zeichnungen angegeben sind.

Es zeigen:
- Fig. 1: ein Ablaufdiagramm eines Verfahrens zum Ausführen eines virtuellen Tests einer Vorrichtung zur zumindest teilweisen autonomen Führung eines Kraftfahrzeugs gemäß einer bevorzugten Ausführungsform der Erfindung; und
- Fig.2: eine schematische Darstellung eines Systems zum Ausführen eines virtuellen Tests einer Vorrichtung zur zumindest teilweisen autonomen Führung eines Kraftfahrzeugs gemäß der bevorzugten Ausführungsform der Erfindung.

Sofern nicht anders angegeben, bezeichnen gleiche Bezugszeichen gleiche Elemente der Zeichnungen.

### Ausführliche Beschreibung der Ausführungsformen

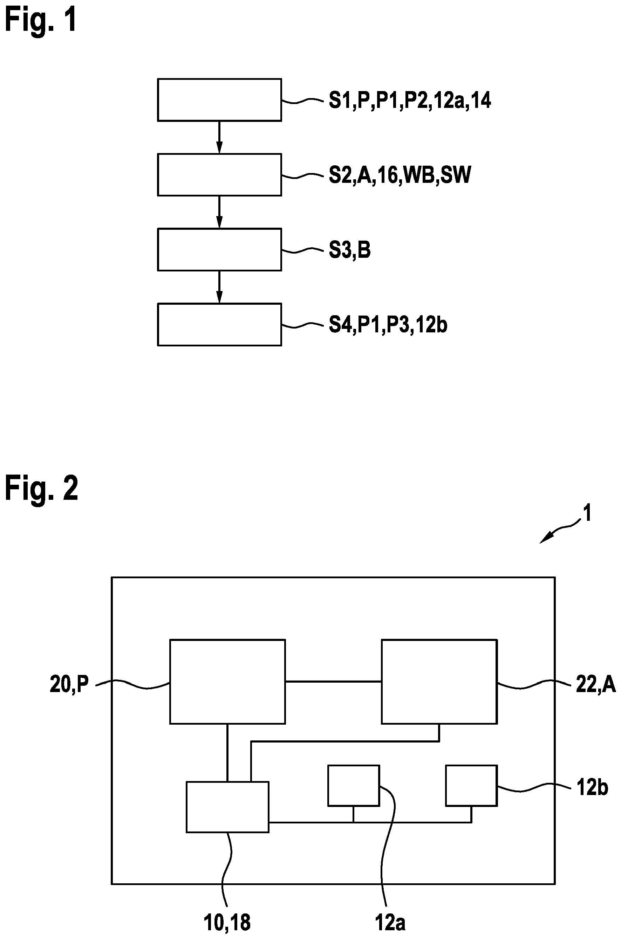

Das in Fig. 1 gezeigte Verfahren umfasst ein Bereitstellen S1 zumindest eines Parametersatzes P von Fahrsituationsparametern, wobei die Fahrsituationsparameter zumindest einen, durch zumindest einen Fahrzeugsensor 12a erfassten ersten Parameter P1 und zumindest einen, zumindest ein weiteres Szenarienobjekt 14 repräsentierenden zweiten Parameter P2 umfassen.

Das Verfahren umfasst ferner ein Ausführen S2 des virtuellen Tests durch einen Algorithmus A unter Verwendung des zumindest eines Parametersatzes P von Fahrsituationsparametern, wobei der durch den Algorithmus A ausgeführte virtuelle Test den zumindest einen Parametersatz P von Fahrsituationsparametern simuliert.

Des Weiteren umfasst das Verfahren ein Überwachen S3 zumindest eines Fahrsituationsparameters des Parametersatzes P von Fahrsituationsparametern, und bei Erfüllen einer vorgegebenen und/oder durch den Algorithmus A bestimmten Bedingung B, Verändern S4 des zumindest einen, durch den zumindest einen Fahrzeugsensor 12a erfassten ersten Parameters P1 und/oder eines, einen Fahrzeugaktor 12b betreffenden dritten Parameters P3 zu einer Laufzeit des virtuellen Tests.

Die vorgegebene und/oder durch den Algorithmus A bestimmte Bedingung B ist erfüllt, wenn zumindest einer der bereitgestellten Fahrsituationsparameter und/oder ein eine Mehrzahl von Fahrsituationsparametern repräsentierender Indikator 16 außerhalb eines vorgegebenen und/oder durch den Algorithmus A bestimmten Wertebereichs WB liegt.

Außerhalb des vorgegebenen und/oder durch den Algorithmus A bestimmten Wertebereichs WB liegende Werte repräsentieren dabei eine sicherheitskritische Fahrsituation, insbesondere dass ein longitudinaler und/oder seitlicher Abstand eines Ego-Fahrzeugs zu einem Fellow-Fahrzeug kleiner oder gleich einem vorgegebenen Schwellwert SW ist.

Die außerhalb des vorgegebenen und/oder durch den Algorithmus A bestimmten Wertebereichs WB liegenden Werte der Fahrsituationsparameter, welche die sicherheitskritische Fahrsituation repräsentieren, liegen innerhalb eines Parameterraums.

Der Algorithmus A bestimmt innerhalb des Parameterraums die sicherheitskritische Fahrsituation repräsentierende Testfälle.

Das Verändern S4 des zumindest einen, durch den zumindest einen Fahrzeugsensor 12a erfassten ersten Parameters P1 und/oder des, den Fahrzeugaktor 12b betreffenden dritten Parameters P3 zur Laufzeit des virtuellen Tests repräsentiert dabei ein Erzeugen eines Ausfalls und/oder einer Fehlfunktion des zumindest einen Fahrzeugsensors 12a und/oder des zumindest einen Fahrzeugaktors.

Das Erzeugen des Ausfalls und/oder der Fehlfunktion des zumindest einen Fahrzeugsensors 12a und/oder des zumindest einen Fahrzeugaktors umfasst eine Unterbrechung einer Kommunikationsverbindung zwischen einem Steuergerät 18 und dem Fahrzeugsensor 12a und/oder Fahrzeugaktor 12b, eine Unterbrechung einer Stromversorgung des Fahrzeugsensors 12a und/oder Fahrzeugaktors und eine Einschränkung einer Leistungsfähigkeit des Fahrzeugsensors 12a, insbesondere aufgrund einer Verschmutzung des Fahrzeugsensors 12a.

Der Algorithmus A bestimmt Variablenwerte für das Erzeugen des Ausfalls und/oder einer Fehlfunktion des zumindest einen Fahrzeugsensors 12a und/oder des zumindest einen Fahrzeugaktors. Der Algorithmus A erzeugt ferner für redundante und/oder unterschiedliche Fahrzeugsensoren 12a widersprüchliche, insbesondere zueinander inkonsistente Daten.

Das Verändern S4 des zumindest einen, durch den zumindest einen Fahrzeugsensor 12a erfassten ersten Parameters P1 und/oder des, den Fahrzeugaktor 12b betreffenden dritten Parameters P3 zur Laufzeit des virtuellen Tests umfasst dabei ein Schreiben einer den zumindest einen Fahrsituationsparameter repräsentierenden Variable.

Der Fahrzeugsensor 12a ist vorzugsweise ein Kamerasensor, ein Radarsensor, ein LiDAR-Sensor, ein Ultraschallsensor oder ein Infrarotsensor.

Alternativ kann der Fahrzeugsensor 12a beispielsweise ein Reifendrucksensor, ein Raddrehzahlsensor und/oder ein GNSS-Sensor, insbesondere ein GPS-Sensor sein. Der Fahrzeugaktor 12b ist beispielsweise ein adaptiver Tempomat, ein Spurhalteassistent, ein aktiver Bremsassistent und/oder ein Parkassistent.

Der durch den Fahrzeugsensor 12a erfasste erste Parameter P1 ist beispielsweise eine Fahrzeuggeschwindigkeit eines Ego-Fahrzeugs, ein Abstand des Ego-Fahrzeugs zu einem vorausfahrenden oder hinterherfahrenden Fellow-Fahrzeugs und/oder eine Beschleunigung oder Verzögerung des Ego-Fahrzeugs und/oder eines Fellow-Fahrzeugs.

Der zumindest eine, zumindest ein weiteres Szenarienobjekt 14 repräsentierende zweite Parameter P2 ist beispielsweise eine Fahrbahnbreite, ein Straßenverlauf, Verkehrszeichen, Verkehrsteilnehmer, Gebäude und/oder eine Vegetation.

Fig.2 zeigt eine schematische Darstellung eines Systems 1 zum Ausführen eines virtuellen Tests einer Vorrichtung 10 zur zumindest teilweisen autonomen Führung eines Kraftfahrzeugs gemäß der bevorzugten Ausführungsform der Erfindung.

Das System 1 umfasst einen Datenspeicher 20, welcher dazu eingerichtet ist, zumindest einen Parametersatz P von Fahrsituationsparametern bereitzustellen, wobei die Fahrsituationsparameter zumindest einen, durch zumindest einen Fahrzeugsensor 12a erfassten ersten Parameter P1 und zumindest einen, zumindest ein weiteres Szenarienobjekt 14 repräsentierenden zweiten Parameter P2 umfassen.

Der Weiteren umfasst das System 1 eine Rechenvorrichtung 22, welche dazu eingerichtet ist, den virtuellen Test durch einen Algorithmus A unter Verwendung des zumindest eines Parametersatzes P von Fahrsituationsparametern auszuführen, wobei der durch den Algorithmus A ausgeführte virtuelle Test den zumindest einen Parametersatz P von Fahrsituationsparametern simuliert, wobei die Rechenvorrichtung 22 ferner dazu eingerichtet ist, zumindest einen Fahrsituationsparameter des Parametersatzes P von Fahrsituationsparametern zu überwachen, und wobei die Rechenvorrichtung 22 ferner dazu eingerichtet ist, bei Erfüllen einer vorgegebenen und/oder durch den Algorithmus A bestimmten Bedingung B, den zumindest einen, durch den zumindest einen Fahrzeugsensor 12a erfassten ersten Parameter P1 und/oder einen, einen Fahrzeugaktor 12b betreffenden dritten Parameter P3 zu einer Laufzeit des virtuellen Tests zu verändern.

Obwohl hierin spezifische Ausführungsformen illustriert und beschrieben wurden, ist es dem Fachmann verständlich, dass eine Vielzahl von alternativen und/oder äquivalenten Implementierungen existieren. Es sollte beachtet werden, dass die beispielhafte Ausführungsform oder beispielhaften Ausführungsformen nur Beispiele sind und nicht dazu dienen, den Umfang, die Anwendbarkeit oder die Konfiguration in irgendeiner Weise einzuschränken.

Vielmehr liefert die vorstehend genannte Zusammenfassung und ausführliche Beschreibung dem Fachmann eine bequeme Anleitung zur Implementierung zumindest einer beispielhaften Ausführungsform, wobei verständlich ist, dass verschiedene Änderungen im Funktionsumfang und der Anordnung der Elemente vorgenommen werden können, ohne vom Umfang der beigefügten Ansprüche und ihrer rechtlichen Äquivalente abzuweichen.

Im Allgemeinen beabsichtigt diese Anmeldung, Änderungen bzw. Anpassungen oder Variationen der hierin dargestellten Ausführungsformen abzudecken. Beispielsweise kann eine Reihenfolge der Verfahrensschritte abgeändert werden. Das Verfahren kann ferner zumindest abschnittsweise sequentiell oder parallel durchgeführt werden.

### Bezugszeichenliste

- 1: System
- 10: Vorrichtung
- 12a: Fahrzeugsensor
- 12b: Fahrzeugaktor
- 14: Szenarienobjekt
- 16: Indikator
- 18: Steuergerät
- 20: Datenspeicher
- 22: Rechenvorrichtung
- A: Algorithmus
- B: Bedingung
- P: Parametersatz
- P1: erster Parameter
- P2: zweiter Parameter
- P3: dritter Parameter
- S1-S4: Verfahrensschritte
- SW: Schwellwert
- WB: Wertebereich

## Patentansprüche

1. Computerimplementiertes Verfahren zum Ausführen eines virtuellen Tests einer Vorrichtung (10) zur zumindest teilweisen autonomen Führung eines Kraftfahrzeugs, mit den Schritten:
Bereitstellen (S1) zumindest eines Parametersatzes (P) von Fahrsituationsparametern, wobei die Fahrsituationsparameter zumindest einen, durch zumindest einen Fahrzeugsensor (12a) erfassten ersten Parameter (P1) und zumindest einen, zumindest ein weiteres Szenarienobjekt (14) repräsentierenden zweiten Parameter (P2) umfassen;
Ausführen (S2) des virtuellen Tests durch einen Algorithmus (A) unter Verwendung des zumindest eines Parametersatzes (P) von Fahrsituationsparametern, wobei der durch den Algorithmus (A) ausgeführte virtuelle Test den zumindest einen Parametersatz (P) von Fahrsituationsparametern simuliert;
Überwachen (S3) zumindest eines Fahrsituationsparameters des Parametersatzes (P) von Fahrsituationsparametern; und
bei Erfüllen einer vorgegebenen und/oder durch den Algorithmus (A) bestimmten Bedingung (B), Verändern (S4) des zumindest einen, durch den zumindest einen Fahrzeugsensor (12a) erfassten ersten Parameters (P1) und/oder eines, einen Fahrzeugaktor (12b) betreffenden dritten Parameters (P3) zu einer Laufzeit des virtuellen Tests.

2. Computerimplementiertes Verfahren nach Anspruch 1, wobei die vorgegebene und/oder durch den Algorithmus (A) bestimmte Bedingung (B) erfüllt ist, wenn zumindest einer der bereitgestellten Fahrsituationsparameter und/oder ein eine Mehrzahl von Fahrsituationsparametern repräsentierender Indikator (16) außerhalb eines vorgegebenen und/oder durch den Algorithmus (A) bestimmten Wertebereichs (WB) liegt.

3. Computerimplementiertes Verfahren nach Anspruch 2, wobei außerhalb des vorgegebenen und/oder durch den Algorithmus (A) bestimmten Wertebereichs (WB) liegende Werte eine sicherheitskritische Fahrsituation repräsentieren, insbesondere dass ein longitudinaler und/oder seitlicher Abstand eines Ego-Fahrzeugs zu einem Fellow-Fahrzeug kleiner oder gleich einem vorgegebenen Schwellwert (SW) ist.

4. Computerimplementiertes Verfahren nach Anspruch 3, wobei die außerhalb des vorgegebenen und/oder durch den Algorithmus (A) bestimmten Wertebereichs (WB) liegenden Werte der Fahrsituationsparameter, welche die sicherheitskritische Fahrsituation repräsentieren, innerhalb eines Parameterraums liegen.

5. Computerimplementiertes Verfahren nach Anspruch 4, wobei der Algorithmus (A) innerhalb des Parameterraums die sicherheitskritische Fahrsituation repräsentierenden Testfälle bestimmt.

6. Computerimplementiertes Verfahren nach einem der vorhergehenden Ansprüche, wobei das Verändern (S4) des zumindest einen, durch den zumindest einen Fahrzeugsensor (12a) erfassten ersten Parameters (P1) und/oder des, den Fahrzeugaktor (12b) betreffenden dritten Parameters (P3) zur Laufzeit des virtuellen Tests ein Erzeugen eines Ausfalls und/oder einer Fehlfunktion des zumindest einen Fahrzeugsensors (12a) und/oder des zumindest einen Fahrzeugaktors (12b) repräsentiert.

7. Computerimplementiertes Verfahren nach Anspruch 6, wobei das Erzeugen des Ausfalls und/oder der Fehlfunktion des zumindest einen Fahrzeugsensors (12a) und/oder des zumindest einen Fahrzeugaktors (12b) eine Unterbrechung einer Kommunikationsverbindung zwischen einem Steuergerät (18) und dem Fahrzeugsensor (12a) und/oder Fahrzeugaktor (12b), eine Unterbrechung einer Stromversorgung des Fahrzeugsensors (12a) und/oder Fahrzeugaktors (12b) und eine Einschränkung einer Leistungsfähigkeit des Fahrzeugsensors (12a), insbesondere aufgrund einer Verschmutzung des Fahrzeugsensors (12a), umfasst.

8. Computerimplementiertes Verfahren nach Anspruch 6 oder 7, wobei der Algorithmus (A) Variablenwerte für das Erzeugen des Ausfalls und/oder einer Fehlfunktion des zumindest einen Fahrzeugsensors (12a) und/oder des zumindest einen Fahrzeugaktors (12b) bestimmt.

9. Computerimplementiertes Verfahren nach einem der vorhergehenden Ansprüche, wobei der Algorithmus (A) für redundante und/oder unterschiedliche Fahrzeugsensoren (12a) widersprüchliche, insbesondere zueinander inkonsistente Daten erzeugt.

10. Computerimplementiertes Verfahren nach einem der vorhergehenden Ansprüche, wobei das Verändern (S4) des zumindest einen, durch den zumindest einen Fahrzeugsensor (12a) erfassten ersten Parameters (P1) und/oder des, den Fahrzeugaktor (12b) betreffenden dritten Parameters (P3) zur Laufzeit des virtuellen Tests ein Schreiben einer den zumindest einen Fahrsituationsparameter repräsentierenden Variable umfasst.

11. Computerimplementiertes Verfahren nach einem der vorhergehenden Ansprüche, wobei der Fahrzeugsensor (12a) ein Kamerasensor, ein Radarsensor, ein LiDAR-Sensor, ein Ultraschallsensor, ein Infrarotsensor, ein Reifendrucksensor, ein Raddrehzahlsensor und/oder ein GNSS-Sensor, insbesondere ein GPS-Sensor ist, und wobei der Fahrzeugaktor (12b) ein adaptiver Tempomat, ein Spurhalteassistent, ein aktiver Bremsassistent und/oder ein Parkassistent ist.

12. Computerimplementiertes Verfahren nach einem der vorhergehenden Ansprüche, wobei der durch den Fahrzeugsensor (12a) erfasste erste Parameter (P1) eine Fahrzeuggeschwindigkeit eines Ego-Fahrzeugs, ein Abstand des Ego-Fahrzeugs zu einem vorausfahrenden oder hinterherfahrenden Fellow-Fahrzeugs und/oder eine Beschleunigung oder Verzögerung des Ego-Fahrzeugs und/oder eines Fellow-Fahrzeugs ist.

13. Computerimplementiertes Verfahren nach einem der vorhergehenden Ansprüche, wobei der zumindest eine, zumindest ein weiteres Szenarienobjekt (14) repräsentierende zweite Parameter (P2) eine Fahrbahnbreite, ein Straßenverlauf, Verkehrszeichen, Verkehrsteilnehmer, Gebäude und/oder eine Vegetation ist.

14. System (1) zum Ausführen eines virtuellen Tests einer Vorrichtung (10) zur zumindest teilweisen autonomen Führung eines Kraftfahrzeugs, mit:
einem Datenspeicher (20), welcher dazu eingerichtet ist, zumindest einen Parametersatz (P) von Fahrsituationsparametern bereitzustellen, wobei die Fahrsituationsparameter zumindest einen, durch zumindest einen Fahrzeugsensor (12a) erfassten ersten Parameter (P1) und zumindest einen, zumindest ein weiteres Szenarienobjekt (14) repräsentierenden zweiten Parameter (P2) umfassen; und
einer Rechenvorrichtung (22), welche dazu eingerichtet ist, den virtuellen Test durch einen Algorithmus (A) unter Verwendung des zumindest eines Parametersatzes (P) von Fahrsituationsparametern auszuführen, wobei der durch den Algorithmus (A) ausgeführte virtuelle Test den zumindest einen Parametersatz (P) von Fahrsituationsparametern simuliert, wobei die Rechenvorrichtung (22) ferner dazu eingerichtet ist, zumindest einen Fahrsituationsparameter des Parametersatzes (P) von Fahrsituationsparametern zu überwachen, und wobei die Rechenvorrichtung (22) ferner dazu eingerichtet ist, bei Erfüllen einer vorgegebenen und/oder durch den Algorithmus (A) bestimmten Bedingung (B), den zumindest einen, durch den zumindest einen Fahrzeugsensor (12a) erfassten ersten Parameter (P1) und/oder einen, einen Fahrzeugaktor (12b) betreffenden dritten Parameter (P3) zu einer Laufzeit des virtuellen Tests zu verändern.

15. Computerprogramm mit Programmcode, um das Verfahren nach einem der Ansprüche 1 bis 13 durchzuführen, wenn das Computerprogramm auf einem Computer ausgeführt wird.
